(19) Europäisches Patentamt
European Patent Office
Office européen des brevets

(11) Numéro de publication: **0 272 161 B1**

(12) **FASCICULE DE BREVET EUROPEEN**

(45) Date de publication de fascicule du brevet: **22.07.92**

(51) Int. Cl.[5]: **H03G 7/00**, H03G 3/00, H03G 1/00, G01R 27/28

(21) Numéro de dépôt: **87402151.2**

(22) Date de dépôt: **25.09.87**

(54) **Procédé et circuit de linéarisation, par échantillons numériques de correction, de la fonction de transfert d'un quadripôle, notamment d'un quadripôle BF à courbe dissymétrique.**

(30) Priorité: **25.09.86 FR 8613401**

(43) Date de publication de la demande:
**22.06.88 Bulletin 88/25**

(45) Mention de la délivrance du brevet:
**22.07.92 Bulletin 92/30**

(84) Etats contractants désignés:
**BE CH DE FR GB IT LI NL SE**

(56) Documents cités:
**DE-A- 2 806 695**
**FR-A- 1 547 723**
**FR-A- 2 577 732**
**GB-A- 1 476 603**
**US-A- 3 836 845**

(73) Titulaire: **ETAT FRANCAIS représenté par le Ministre des PTT (Centre National d'Etudes des Télécommunications)**
**38-40 rue du Général Leclerc**
**F-92131 Issy-les-Moulineaux(FR)**

Titulaire: **Etablissement Public de Diffusion dit "Télédiffusion de France"**
**21-27 rue Barbès**
**F-92120 Montrouge(FR)**

(72) Inventeur: **Charbonnel, Pierre**
**2, rue Surcouf**
**F-35830 Betton(FR)**

(74) Mandataire: **Rodhain, Claude et al**
**Cabinet Claude Rodhain 30, rue la Boétie**
**F-75008 Paris(FR)**

EP 0 272 161 B1

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).

Rank Xerox (UK) Business Services

**PROCEEDINGS OF THE 14TH EUROPEAN MICROWAVE CONFERENCE, 10-13 septembre 1984, Liège, BE, Supported by SITEL - The Société Belge des Ingénieurs de Télécommunication et d'electronique, pages 549-554, Microwave Exhibitions and Publishers Ltd., Tunbridge, Wells, Kent, GB; M. HORN et al.: "Design and performance of microwave predistortion networks using digital circuits**

**JOURNAL OF THE AUDIO ENGINEERING SOCIETY, vol. 25, no. 12, décembre 1977, page 1033 - 1038, New York, US; W.G. JUNG: "Application considerations of IC data converters useful in audio-signal processing"**

**1985 IEEE - MTT-S INTERNATIONAL MICROWAVE SYMPOSIUM DIGEST, 4-6 juin 1985, St. Louis, Missouri, pages 99-102, IEEE, New York, US; M. NANNICINI et al.: "Temperature controlled predistortion circuits for 64 OAM microwave power amplifiers"**

## Description

L'invention a pour objet de fournir un dispositif permettant la linéarisation de la fonction de transfert en amplitude d'un quadripôle quelconque par correction du signal d'entrée ou du signal de sortie du quadripôle, sur la base d'un échantillonnage numérique de la fonction de transfert réelle du quadripôle.

L'invention a plus particulièrement pour objet de fournir un dispositif de linéarisation de la fonction de transfert de quadripôles à courbe dissymétrique fonctionnant en basse fréquence.

La non linéarité importante de certains composants électroniques (photo-diodes émissives, par exemple) limite considérablement leur dynamique utile.

A titre d'exemple, une diode photo-émissive dont l'excursion maximale admissible est de 50 mA, présente une dynamique utile Dnc (fig.2) de 4 mA pour un affaiblissement de distorsion de 0,3% (50 dB). Dans ce cas, 10% seulement de la dynamique est utilisable. Si l'on pouvait linéariser la réponse de cette diode jusqu'à une amplitude correspondant au seuil de dissipation, on pourrait, en l'occurrence, augmenter la dynamique de 20 dB ($Dc-D_{nc}$).

On connaît déjà différents systèmes utilisés pour linéariser des quadripôles.

A titre d'exemple, K.Asatani et T.Kimura présentent dans l'article "Linearization of LED non linearity by Prédistorsions", (en français : linéarisation par prédistorsions de diodes LED non linéaires) paru dans la revue IEEE, vol.ED-25, n° 2, février 1978, les caractéristiques et inconvénients de quelques unes de ces méthodes de linéarisation appliquées aux diodes LED. Celles-ci peuvent être regroupées en quatre grands principes :

- la prédistorsion;
- les contre-réactions diverses (entrée, sortie...);
- la distorsion complémentaire;
- la modulation de déphasage.

Dans le cas de la prédistorsion, les auteurs préconisent de corriger les dérives en gain et en phase d'une diode LED par rapport à une réponse idéalement linéaire, au moyen d'un circuit logique de compensation en temps réel monté en amont de la diode LED, ce circuit comprenant des jeux de résistance sélectivement commutés dans et hors du circuit par diodes de commande. Les valeurs des résistances, et les seuils de déclenchement des diodes de commande sont choisis en fonction d'un diagramme préétabli de la fonction de transfert de la LED à linéariser.

Or, ce type de circuit présente l'inconvénient d'être peu précis, sauf à multiplier les diodes et résistances d'ajustement, et dépourvu de toutes capacités d'adaptation à l'évolution de la fonction de transfert du fait qu'il s'agit d'un circuit câblé.

On connaît également le procédé de contre-réaction négative, faisant intervenir une boucle de contre-réaction dont le gain et la linéarité conditionnent l'efficacité dans la compensation des distorsions. En tout état de cause, cette technique ne fournit qu'une compensation approximative.

D'autres méthodes de contre-réaction impliquent l'utilisation d'un second quadripôle complémentaire du quadripôle principal, par exemple une deuxième LED dans le cas discuté ci-dessus, le quadripôle complémentaire générant un signal de prédistorsion ou de correction a posteriori. Ces procédés ne sont ici encore correctifs que dans une certaine mesure et ne sont pas auto-adaptatifs.

Le procédé de linéarisation par modulation de déphasage implique de disposer de deux quadripôles de propriétés identiques, voire davantage si l'on souhaite compenser simultanément les distorsions harmoniques de deuxième et troisième ordres.

D'autres systèmes ont également été élaborés pour linéariser des transducteurs analogiques, mais ils font intervenir généralement des processus analogiques. Il semble en outre que des multiplexeurs aient été utilisés dans le même but.

En tout état de cause, tous ces systèmes décrits présentent généralement des performances satisfaisantes, mais de précision limitée. Ils sont le plus souvent intégrés au montage, et ne permettent pas une correction a posteriori, à l'exception de la prédistorsion. Ils sont en outre adaptés à un composant électronique déterminé, et ne s'adaptent ni à l'évolution dans le temps de la fonction de transfert du composant, ni a fortiori à d'autres composants.

On connaît également un système de linéarisation, par prédistorsion, d'un amplificateur hyperfréquence en amplitude et en phase, au moyen d'une technique d'échantillonnage numérique ("Design and performance of microwave predistortion neworks using digital circuits" HORN et al., in PROCEEDINGS OF THE 14TH EUROPEAN MICROWAVE CONFERENCE 10-13 septembre 1984, Liège, Belgique, pages 549-554).

Cet article divulgue un principe de linéarisation des amplificateurs hyperfréquences du type des T.O.P., ou du type GaAs FET, au moyen d'un système de prédistortion en FI.

On connaît également un système de prédistortion pour amplificateur hyperfréquence destiné à corriger des dérives d'origine thermique, tel que décrit dans l'article "Temperature controlled predistortion circuits for 64 QAM microwave power amplifiers" NANNICINI et al. in 1985 IEEE - MTT-S INTERNATIONAL MICROWAVE SYMPOSIUM DIGEST, 4-6 juin 1985, St. Louis, Missouri, pages 99-102.

Dans un des modes de réalisation présentés dans ce document (page 101 ; fig.7), le signal issu d'un capteur de température est numérisé avant de commander un circuit de prédistortion par l'intermédiaire d'une logique de contrôle.

Ces systèmes de prédistortion ne sont pas applicables à la linéarisation des quadripôles fonctionnant en fréquence basse, tels que les amplificateurs audio, les diodes et transistors, les capteurs et autres, fonctionnant en fréquence audio.

De plus, la linéarisation par échantillonnage numérique nécessite des adaptations spécifiques dans le cas des éléments à courbe de transfert dissymétrique, comme les courbes sensitométriques, les courbes de diodes photoémissives, etc.... Enfin, la mise en oeuvre de systèmes de linéarisation autoadaptatifs n'implique pas les mêmes concepts en haute fréquence et en basse fréquence.

En conséquence, l'objectif de l'invention est de pallier ces divers inconvénients des dispositifs existants, au moyen d'un dispositif auto-adaptatif de linéarisation de la fonction de transfert en amplitude d'un quadripôle quelconque, permettant d'effectuer une correction à toute la précision souhaitée et qui soit d'une complexité et d'un coût de fabrication réduits.

Un objet complémentaire de l'invention est de fournir un tel dispositif permettant de suivre l'évolution de la fonction de transfert d'un quadripôle donné, alors même que ce quadripôle est en fonctionnement, afin d'adapter le processus de linéarisation aux modifications de son comportement sous l'effet par exemple du vieillissement ou d'influences thermiques.

L'invention a également pour objet subsidiaire de permettre non seulement la linéarisation de composants électroniques, mais également la conformation de leur fonction de transfert à un modèle idéal quelconque, en fonction des besoins.

L'invention a enfin également pour objet de permettre une linéarisation de quadripôles à courbe dissymétrique, fonctionnant en basse fréquence, par échantillonnage numérique, avec le cas échéant, une régénération des échantillons numériques de correction.

Ces objectifs, ainsi que d'autres qui apparaîtront par la suite sont atteints à l'aide d'un dispositif autoadaptatif pour linéariser la fonction de transfert d'un quadripôle, le quadripôle délivrant un premier signal de sortie en réponse à un premier signal d'entrée selon des caractéristiques de réponse en amplitude connues, le dispositif comprenant un moyen de conversion analogique/numérique pour numériser le premier signal de sortie, un moyen de mémorisation de coefficients de correction des caractéristiques de réponse en amplitude du quadripôle, adressé par le moyen de numérisation, un moyen de correction du premier signal de sortie commandé par le moyen de mémorisation pour compenser les défauts de linéarité du quadripôle,

remarquable en ce qu'il comprend en outre:

- un moyen générateur d'échantillons numériques;
- un moyen de conversion numérique/analogique sensible au moyen générateur pour fournir un second signal d'entrée;
- un moyen sélecteur de signaux analogiques, sensible au moyen générateur, pour fournir l'un des deux signaux d'entrée au quadripôle et pour fournir un second signal de sortie du quadripôle au moyen de conversion analogique/numérique lorsque le second signal d'entrée est fourni au quadripôle;
- un moyen de commande et de calcul relié au moyen de mémorisation, au moyen de conversion analogique/numérique et au moyen générateur d'échantillons numériques pour charger dans le moyen de mémorisation des nouveaux coefficients de correction, les nouveaux coefficients de correction étant calculés à partir des échantillons numériques et du second signal de sortie numérisé.

D'autres caractéristiques et avantages de l'invention apparaîtront à la lecture de la description suivante de modes de réalisation préférentiels et non limitatifs de l'invention, et des dessins annexés dans lesquels :

- la figure 1 est un schéma synoptique illustrant un procédé de linéarisation par mémoire morte;
- la figure 2 est un graphe illustrant l'accroissement de la dynamique utilisable d'un quadripôle permis par l'utilisation d'un procédé de linéarisation;
- la figure 3 représente un mode de réalisation particulier d'un circuit de linéarisation suivant l'invention;
- la figure 4 représente schématiquement un circuit de numérisation de la fonction de transfert d'un quadripôle permettant la mémorisation de la fonction de transfert sur une mémoire morte utilisable ensuite dans le procédé de linéarisation suivant l'invention;
- la figure 5 représente schématiquement un mode de réalisation de l'invention dans lequel le circuit de linéarisation selon l'invention coopère avec un circuit de numérisation de la fonction de transfert réelle avant correction du quadripôle à linéariser, auquel le quadripôle peut être momentanément commuté;

- la figure 6 représente une version plus élaborée du circuit de la figure 5, dans laquelle l'étape de numérisation de la fonction de transfert du quadripôle est précédée d'une étape de détermination de sa gamme de fonctionnement.
- la figure 7 illustre schématiquement le procédé de linéarisation de la figure 1, complété par des moyens de compensation de la dérive en température du quadripôle;
- les figures 8a-8b représentent un circuit de linéarisation d'un optocoupleur polarisé, avec repolarisation numérique (fig.8a), et analogique (fig.8b);
- la figure 9 représente un circuit de linéarisation pour optocoupleur, selon l'invention, avec repolarisation numérique, en version autoadaptative;
- la figure 10 est un organigramme représentatif du fonctionnement du circuit de la figure 9
- la figure 11 est un mode de réalisation indicatif de l'optocoupleur linéarisé par les circuits des figures 8a, 8b.

La figure 1 schématise un mode de réalisation du procédé et d'un circuit de linéarisation de la fonction de transfert d'un quadripôle 10 au moyen d'un circuit de correction 11 monté en série, en aval du quadripôle 10 à linéariser.

Le circuit de correction 11 est constitué de moyens de correction 12 du signal de sortie Y du quadripôle 10, en l'occurrence le multiplieur 12. Ce multiplieur 12 est asservi par un circuit numérique de commande comprenant d'une part une ligne 13 de prélèvement du signal Y analogique de sortie du quadripôle 10, d'autre part, un convertisseur 14 analogique-numérique d'échantillonnage de ce signal de sortie, et enfin une mémoire morte 15 dont les entrées-adresses sont commandées par les échantillons numérisés $Y_n$ issus du convertisseur 14 pour attaquer les entrées numériques du multiplieur 12 au moyen d'échantillons de commande $C_n$.

En conséquence, pour chaque niveau du signal de sortie Y du quadripôle 10, un échantillon de commande $C_n$ est généré par le circuit de correction 11, pour commander le gain du multiplieur 12 nécessaire pour compenser la distorsion instantanée en amplitude du quadripôle.

La description qui suit a pour objet de présenter plusieurs versions réalisables de l'invention.

Plus précisément, les points suivants seront abordés ci-après :

- condition théorique du fonctionnement du mode de réalisation de la figure 1, concernant une version de linéarisation par correction du signal de sortie Y du quadripôle 10;
- brève description de la version de linéarisation par correction du signal d'entrée;
- champ d'application du mode de réalisation de la figure 1;
- extension du mode de réalisation de la figure 1 à la prise en compte complémentaire des dérives en températures en relation avec la figure 7;
- extension du mode de réalisation de la figure 1 à la prise en compte complémentaire des dérives en température en relation avec la figure 7;
- extension du mode de réalisation de la figure 1 à une application de l'invention en fonctionnement rapide, en liaison avec une description détaillée de sa mise en oeuvre pratique dans le circuit de la figure 3;
- extension du mode de réalisation de la figure 1 à un procédé et un circuit intégrant la numérisation de la fonction de transfert du quadripôle à linéariser, par intermittence, au cours du processus de linéarisation du signal principal. La description de ces versions qui correspondent aux figures 5 et 6, est précédée de la description du circuit préférentiel de numérisation de la figure 4.
- application de l'invention à la linéarisation d'un optocoupleur polarisé fonctionnant en basse fréquence.

Il faut bien voir en effet que le principe de fonctionnement du procédé du circuit de linéarisation de l'invention est construit autour de l'utilisation, plus ou moins directe suivant les versions, de la mémoire 15 de stockage sous forme numérique de la fonction de transfert du quadripôle à linéariser. C'est en effet cette mémoire qui est chargée, plus ou moins directement suivant les versions, de fournir aux moyens de correction, (multiplieur 12) du signal de sortie Y du quadripôle (ou éventuellement du signal d'entrée X) les échantillons de commande $C_n$, à partir des échantillons $Y_n$ ($X_n$ respectivement) représentatifs du signal principal traversant le quadripôle 10.

Plus précisément, on peut distinguer de façon non exhaustive, deux principes de réalisation de cette mémoire 15. Ces deux principes sont en relation avec la méthode de numérisation de la fonction de transfert d'un quadripôle quelconque telle qu'elle sera détaillée plus loin à propos de la figure 4. Le principe général du fonctionnement de ce circuit de numérisation consiste à générer des couples d'échantillons ($X_n$, $Y_n$) de valeurs correspondantes d'entrée et de sortie du quadripôle (courant ou tension) dont la séquence fournit une représentation de la fonction de transfert d'autant plus précise que la résolution et la fréquence d'échantillonnage de la numérisation sont élevées et que la plage testée de la dynamique du quadripôle est réduite. En conséquence les deux principes non limitatifs suivants sont envisageables, pour exploiter la séquence des couples ($X_n$, $Y_n$ ) :

- la mémoire 15 du circuit de linéarisation de la figure 1 est chargée, a posteriori, de couples ($Y_n$ , $C_n$) ou ($X_n$, $C_n$), dans le cas d'une correction de signal d'entrée, après calcul des échantillons $C_n$ soit à la main soit par machine. Le calcul des échantillons de correction $C_n$ dépend bien entendu, d'une part des caractéristiques des moyens de correction (multiplieur 12), et d'autre part de la pente optimale choisie pour la fonction de transfert du quadripôle.
- une deuxième solution consiste à utiliser telle quelle la mémoire chargée dans le circuit de numérisation de la figure 3 et ne contenant que la séquence des couples ($X_n$, $Y_n$ ). Dans ce cas, le circuit de correction 11 doit comprendre un processeur d'exploitation des couples ($X_n$, $Y_n$ ), de façon à générer par calcul, les coefficients $C_n$.

On notera que ce second principe de réalisation de la mémoire 15 correspond à une extension plus universelle du circuit de correction 11 de la figure 1, pour ce qui est de sa capacité à fonctionner avec pratiquement n'importe quel quadripôle 10. En effet, le changement de quadripôle s'accompagne du simple remplacement de la PROM 15 par une nouvelle PROM chargée de la nouvelle séquence ($X_n$, $Y_n$ ) correspondant au nouveau quadripôle, telle qu'elle est directement obtenue à l'aide du circuit de la figure 3. En revanche, la génération des échantillons de commande $C_n$ serait alors obtenue par processeur lié au circuit de correction 11 et programmé spécifiquement en fonction des caractéristiques (inchangées) du multiplieur 12.

On notera également que de façon préférentielle, la pente de référence de la fonction de transfert après correction du quadripôle 10 est celle de la partie "naturellement" linéaire, comme représenté en figure 2. Dans ce cas, la fonction de transfert 20 après correction s'étend dans le prolongement de la fonction de transfert "naturelle" non corrigée 21. Toutefois, on peut envisager d'autres principes de linéarisation dans lesquels la pente de la fonction de transfert corrigée correspondrait à la moyenne des pentes de la fonction de transfert non corrigée, ce qui peut présenter l'avantage de diminuer la valeur maximale de correction. D'une façon large, mais entrant également dans le cadre de l'invention, il est également possible de prendre pour fonction de transfert idéale une fonction de transfert non linéaire. Dans ce dernier cas, les échantillons de commande $C_n$ pourront être calculés en référence à un modèle de fonction de transfert indépendant de la fonction de transfert non corrigée du quadripôle.

Les conditions théoriques de fonctionnement du circuit de la figure 1 sont les suivantes. La réponse Y au signal d'entrée X du quadripôle 10 non linéaire est : Y = QX. La condition de linéarité aux bornes X, Z du quadripôle 10 connecté au circuit correcteur 11 s'exprime par la relation : Z = A•X (A étant une constante).

Pour vérifier cette condition, le gain $M(C_n)$ du multiplieur commandé numériquement peut s'exprimer sous la forme :

$$M(C_n) = A \bullet DELTA\ (t-nTe)/Q$$

où DELTA(t-nTe) correspond à l'échantillonnage de période Te du signal de commande $C_n$ par train d'impulsions de Dirac.

La fréquence d'échantillonnage $f_e = 1/T_e$ du signal de commande du multiplieur 12 doit être choisie de façon à satisfaire à deux conditions limites:

- le théorème de Shannon doit être respecté. Ce théorème énonce que la fréquence d'échantillonnage doit être au moins deux fois supérieure à la fréquence la plus forte des composantes du signal à échantillonner. Cette exigence fournit la limite inférieure de la fréquence d'échantillonnage du circuit numérique de commande 14, 15, des moyens de correction 11 selon l'invention.
- la période d'échantillonnage doit en outre être supérieure au temps d'établissement du multiplieur 12, afin de permettre la prise en compte par le multiplieur de chaque échantillon $C_n$ de commande. Cette seconde condition constitue la limite supérieure de la fréquence d'échantillonnage.

Lorsque ces deux conditions sont respectées, et dans la pratique on préfèrera choisir une fréquence d'échantillonnage la plus proche possible par défaut du temps d'établissement du multiplieur 12, la linéarisation du quadripôle 10 peut être obtenue avec toute la précision voulue, pourvu qu'on fasse un choix adéquat des performances des éléments 12, 14, 15 du circuit correcteur.

Les caractéristiques critiques de ces éléments sont notamment la résolution du convertisseur CAN 14, la résolution du multiplieur 12 et le rapport entre la fréquence maximale du signal principal Y et la fréquence d'échantillonnage.

Ce système permet de corriger les discontinuités du premier et du deuxième ordres, ainsi que des variations de pente très importantes de la fonction de transfert du quadripôle 10. Toutefois, il faut savoir que, plus la variation de pente est importante, moins la précision de la correction est bonne. D'autre part, on notera que la résolution du convertisseur 14 et du multiplieur 12 doit être choisie non en fonction de la dynamique d'entrée mais bien de la dynamique de sortie du circuit correcteur 11.

Le circuit représenté en figure 1 correspond à un mode de réalisation où le quadripôle 10 est linéarisé par correction de son signal de sortie Y. Or, l'invention s'applique tout aussi bien à la linéarisation d'un quadripôle par correction de son signal d'entrée. Cette solution est notamment judicieuse dans le cas d'un quadripôle présentant un fort gain, à condition d'éviter la saturation.

Toutefois, ce mode de réalisation est moins avantageux dans le cas qui sera discuté par la suite en relation avec les figures 5 et 6, où le calcul des coefficients de commande $C_n$ dumultiplieur 12 est effectué en cours de processus, par circuit de numérisation momentanément commuté sur le quadripôle. En effet, il est alors nécessaire de compenser non seulement le temps de traitement des coefficients $C_n$,mais également le temps de transfert du quadripôle, ce qui constitue une contrainte importante pour la ligne à retard analogique du signal principal, avant correction.

Le champ d'application du circuit de la figure 1 est relativement large. Ainsi, le circuit correcteur 11 peut être de quatre types, à savoir :

- tension-tension;
- tension-courant;
- courant-tension;
- courant-courant.

Le circuit de correction 11 de la figure 1 fonctionne directement selon le principe tension-tension lorsque les moyens de correction sont constitués du multiplieur 12. Les trois autres versions sont réalisées au moyen d'un amplificateur-adaptateur incorporé à la sortie du multiplieur 12 (correction tension-courant) ou à l'entrée du multiplieur (courant-tension; courant-courant).

Moyennant l'adjonction de ces amplificateurs lorsque nécessaire, le circuit correcteur de la figure 1 peut être employé tel quel pour des applications lentes, correspondant notamment à la linéarisation de fonctions d'instrumentation utilisant des thermo-couples, des capteurs lents ou équivalents. Il est toutefois souhaitable de filtrer la sortie Z du circuit, de façon à supprimer les effets de parasites de commutation ("glitches").

En revanche, dans le cas d'application à des circuits rapides, comme on le verra en liaison avec la figure 3, il est nécessaire d'appliquer à cette version de base de la figure 1 des filtres, et une tête d'échantillonnage.

Un prototype du circuit de la figure 1 a été réalisée pour appliquer ce système à la linéarisation d'un coupleur électronique, et est représenté en figure 3. Le principe de réalisation était le suivant.

On a tout d'abord relevé la fonction de transfert en courant de la diode octo-électronique, qui a été ensuite échantillonnée et quantifiée selon une résolution compatible avec celle du convertisseur 14 et du multiplieur 12. Cette numérisation de la fonction de transfert a été réalisée au moyen du dispositif tel que représenté en figure 4 et qui sera détaillé par la suite. La fonction de transfert a été échantillonnée sous forme d'une séquence de couples ($X_n$, $Y_n$).

On a ensuite déterminé les coefficients de commande du multiplieur 12 à partir des couples ($X_n$, $Y_n$), puis mis les $C_n$ en PROM 15. Le calcul de ces coefficients peut se faire manuellement ou par logiciel.

Le circuit réalisé comportait les éléments suivants :

- un multiplieur 12 quadrants d'une résolution de 12 eb du type AD 7531;
- un échantillonneur-bloqueur 41 du type MP271, ANALOGIC (®) ;
- un convertisseur CAN 14, d'une résolution de 14eb (MP 2734 ANALOGIC (®));
- deux mémoires mortes 15 (type 2732 NEC (®), TEXAS (®), etc... ;
- deux circuits logiques 42, 43 (type 74LF 174 à sortie parallèle);
- un filtre de lissage, monté en sortie du multiplieur, avec une réjection de 12 db par octave dans la bande atténuée.

L'échantillonneur-bloqueur 41 a pour objet de préserver la précision de la quantification aux fréquences élevées du spectre utile.

Le filtre de lissage doit simultanément supprimer les parasites de commutation ("glitches"), et les effets de maintien en sortie du multiplieur 12.

Le fonctionnement de cette maquette est pour l'essentiel le suivant.

Le signal de sortie Y du quadripôle à linéariser est tout d'abord traité par l'échantillonneur-bloqueur 41, avant d'être introduit dans le convertisseur 14. Les échantillons numérisés générés par le CAN 14 sont sortis sur 12 eb B1 à B12, et envoyés aux entrées-adresse des deux PROM 15 à travers les circuits logiques de gestion 42, 43. Les PROM 15 restituent alors les échantillons de commande $C_n$ du multiplieur 12, sur 12 eb XB1 à XB12. Le multiplieur 12 corrige alors le signal de sortie Y en fonction de ces échantillons de commande, de façon à compenser les défauts de linéarité du quadripôle.

Avec la résolution de 12 eb qui a été choisi pour ce prototype, et une taille mémoire des PROM de 4,096 Ko, on a ramené l'erreur de linéarité de l'optocoupleur à une valeur inférieure à 0,024%. La fréquence maximale du spectre utile du signal principal était de 20 kHz et la fréquence d'échantillonnage du circuit correcteur de 80 kHz.

La dynamique du niveau d'entrée du circuit correcteur était de +10 volts pour l'isolateur opto-électronique à réaliser. Cette dynamique correspondait à une variation du circuit d'entrée de 1,2 Volt à 5 Volts, (au lieu d'une excursion de 0,1 V avant correction) et donc à une augmentation de la dynamique de 31,6 dB.

En conséquence, le circuit correcteur s'est traduit par un double bénéfice :

- la possibilité d'utiliser l'isolateur sur une dynamique plus grande, en portant ainsi le rapport signal/bruit à 111,5 dB alors qu'il était à l'origine de 80 dB;
- le maintien d'une erreur de linéarité sur la totalité de la dynamique utile à une valeur inférieure à 0,024%.

Sur ce dernier point, la performance du circuit correcteur est liée à la résolution du convertisseur et du multiplieur conformément au tableau ci-contre:

**TABLEAU 1**

**ERREUR MAXIMALE DE LINEARITE EN FONCTION DE LA RESOLUTION**

| Résolution | 8 | 9 | 10 | 11 | 12 | 13 | 14 | 15 | 16 |
|---|---|---|---|---|---|---|---|---|---|
| (%) Erreur de linéarité | 0,4 | 0,2 | 0,098 | 0,049 | 0,024 | 0,012 | 0,006 | 0,003 | 0,0015 |
| Capacité mémoire des PROM (octets) | 256 | 512 | 1024 | 2048 | 4096 | 8192 | 16384 | 32768 | 5536 |

La figure 4 concerne un procédé et un dispositif de numérisation de l'amplitude de la fonction de transfert d'un quadripôle 34 qui fait l'objet d'une demande de brevet conjointe.

Dans la version représentée, ce dispositif de numérisation comporte une unité centrale 31 commandée par console de visualisation 32 via une liaison V24 (normalisation CCITT), une mémoire 33 de stockage des programmes et des données, et une carte d'interface 35, 36 du quadripôle sous test 34 au bus de données unique 30 autour duquel est structuré le dispositif. IL comporte en outre une carte de programmation 37 pour le chargement des échantillons de la fonction de transfert du quadripôle 34 sur mémoire morte PROM.

Le fonctionnement de ce dispositif est le suivant:

- la carte CPU 31 échantillonne un signal rampe numérique selon un incrément prédéterminé, qui est multiplexé et inséré dans le bus de données 30;
- les interfaces 35, 36 récupèrent le signal rampe, et le convertissent en signal analogique d'entrée pour le quadripôle 34, puis réinsèrent dans le bus de donnée 30 le signal de sortie correspondant du quadripôle 34, après numérisation et multiplexage;
- la carte de programmation 37 stocke alors les couples d'échantillons $X_n$, $Y_n$ d'entrée et de sortie respectivement du quadripôle 34 sur mémoire PROM.

De façon avantageuse, la résolution, la période et la plage d'échantillonnage du signal d'entrée $X_n$ sont variables et commandées par l'unité de traitement 31 à microprocesseur. Lorsque les caractéristiques des composants utilisés le permettent, la résolution et la période d'échantillonnage sont choisies en fonction de la vitesse de travail du système de façon à permettre un relevé de la fonction de transfert du quadripôle 34 en temps réel.

La mémoire PROM chargée par un circuit de programmation 37 peut être utilisée directement dans le circuit de linéarisation de la figure 1, si celui-ci est muni d'un processeur de calcul des échantillons de commande $C_n$. En revanche, la mémoire PROM doit être chargée préalablement avec des couples ($Y_n$, $C_n$) ou ($X_n$, $C_n$) si le fonctionnement retenu se limite à celui illustré par la figure 1. Dans ce cas, le calcul des échantillons $C_n$ peut être réalisé à l'aide du circuit de numérisation de la figure 4, pourvu que l'unité centrale 31 soit programmée en conséquence, par exemple.

Les figures 5 et 6 illustrent deux modes de réalisation de l'invention dans lesquels un circuit de numérisation du type de celui de la figure 4 est associé au circuit de linéarisation du quadripôle, de façon à insérer périodiquement une opération (très rapide) de (re-) numérisation de la fonction de transfert du quadripôle, au sein même du processus principal auquel prend part le quadripôle 10 à linéariser.

Le principe de fonctionnement est alors le suivant.

Le circuit principal de fonctionnement du quadripôle 10 à linéariser est constitué, à titre d'exemple, d'un premier amplificateur 51, du commutateur 50, du quadripôle 10, du circuit de correction 11 coopérant avec la mémoire 15, et de l'amplificateur de sortie 52.

Le commutateur 50 permet d'ouvrir le circuit principal et de faire passer le quadripôle 10 sur un circuit de numérisation de sa fonction de transfert. Ce circuit de numérisation est du type représenté en figure 4, et comprend un jeu de convertisseurs 53, 54, à savoir un convertisseur numérique-analogique 53 pour l'alimentation du quadripôle 10 en échantillons analogiques d'entrée $X_n$, et un convertisseur analogique-numérique 54 de numérisation des échantillons de sortie $Y_n$ du quadripôle 10; une carte d'interface 36 pour la communication avec le bus 30; l'unité centrale 31 de génération des échantillons $X_n$, et un processeur rapide 55 de chargement de la mémoire 15 avec des échantillons de commande $C_n$ correspondant à chaque valeur de sortie $Y_n$ du quadripôle 10.

Le processeur 55 commande également, le cas échéant, le fonctionnement du commutateur 50.

Le circuit correcteur 11 est par exemple du type de celui de la figure 1, à la différence que la mémoire 15 est une RAM, partagée avec le circuit de numérisation à travers la ligne 56.

On distingue donc deux phases, en fonction de la position du commutateur 50 :

- une phase de mesure, dans laquelle le commutateur est dans la position représentée en figure 5. La carte à microprocesseur 31 génère les échantillons $X_n$ qui attaquent le convertisseur CNA 53. Les échantillons analogiques $Y_n$ de sortie du quadripôle 10 attaquent en retour un convertisseur CAN fournissant les échantillons $Y_n$. Le processeur 55 calcule alors les échantillons $C_n = A(Y_n/X_n)$, qui sont mis en mémoire dans la RAM 15;
- une phase opérationnelle, dans laquelle le commutateur 50 est positionné de façon à fermer le circuit principal. Le fonctionnement est alors conforme au principe décrit en relation avec la figure 1.

Suivant la façon dont on alterne la phase de mesure et la phase opérationnelle, on peut distinguer deux modes de fonctionnement.

Dans le premier mode, les coefficients $C_n$, correspondent à toute la dynamique du quadripôle à linéariser, sont calculés en début de processus puis périodiquement; ou encore à la demande. Cette méthode présente l'inconvénient de nécessiter l'interruption du signal principal durant le temps d'acquisition, de calcul, et de transfert en RAM 15 des coefficients $C_n$. Ces interruptions peuvent s'étendre sur une durée relativement importante pour les calculs à haute résolution par exemple si l'on souhaite produire 4096 échantillons à 12 eb. de résolution.

Une variante de cette méthode consiste à échantillonner le signal principal, et à multiplexer ces échantillons utiles avec les échantillons $X_n$, $Y_n$ du circuit de numérisation, ce qui permet d'assurer la continuité du signal principal tout en rafraîchissant périodiquement la RAM 15 du circuit correcteur 11.

Cette variante est particulièrement intéressante dans le cas de correction à haute résolution dans la mesure où elle n'implique pas de limitation de durée pour l'acquisition $X_n$,$Y_n$. Elle suppose toutefois que le quadripôle 10 ait un temps de montée suffisamment faible pour que la durée de passage de la valeur minimale à la valeur maximale de sa dynamique représente moins de la moitié de la période d'échantillonnage choisie.

Cette variante est donc à réserver aux processus lents (applications industrielles), mais nécessitant une grande linéarité.

- Le deuxième mode de fonctionnement de ce dispositif correspond à la figure 6. Dans ce mode de réalisation, le relevé de la fonction de transfert du quadripôle 10 effectué en cours du processus principal, ne porte à chaque fois que sur la plage instantanée de fonctionnement du quadripôle.

A cet effet, le circuit de la figure 6 est analogue à celui de la figure 5, mais comporte en plus un détecteur de plage de fonctionnement matérialisé par l'interrupteur $I_1$, et une ligne à retard analogique 61 précédant le circuit de correction 11.

Le fonctionnement de ce circuit est le suivant.

Tout d'abord, la détection de gamme est effectuée en fermant l'interrupteur $I_1$ sur l'amplificateur 51 de façon à faire acquérir le niveau instantané du signal principal par le processeur 60 via le convertisseur 54. Le micro 60 opère alors une mesure de linéarité différentielle sur une plage donnée autour de la valeur détectée. Pour ce faire, l'interrupteur I3 est basculé sur le convertisseur 53 et les interrupteurs I1, I2 sur le convetisseur 54 afin d'amener le quadripôle 10 en phase de mesure. Les coefficients de commande $C_n$ sont alors calculés sur la plage précédemment déterminée.

Les interrupteurs I2, I3 sont ensuite basculés sous le circuit principal de façon à poursuivre le processus principal.

Ce mode de réalisation présente l'avantage de corriger le signal en temps réel, sans nécessiter un temps de montée important. Il permet en outre, d'obtenir une linéarité aussi précise que l'on veut, la précision étant d'autant plus grande que la plage instantanée de numérisation est plus faible et donc, que le nombre de plages est important. Simultanément la durée d'acquisition et de calcul des échantillons de mesure est réduite à résolution égale, avec une diminution correspondante de la capacité nécessaire de la mémoire du circuit de correction.

La figure 7 est relative à une version du mode de réalisation du circuit de correction 11 de la figure 1, où on a ajouté des moyens complémentaires de compensation de la dérive en température susceptible d'affecter la fonction de transfert du quadripôle 10 à linéariser.

Selon ce circuit, un circuit d'addition 70 intercalé entre le convertisseur 14 et la PROM 15 ajoute des échantillons de correction $O_n$ aux échantillons $Y_n$ de sortie non corrigée du quadripôle 10 à linéariser. Chaque échantillon de correction $O_n$ peut être uniquement fonction de la dérive en température, ou encore être variable en fonction de la valeur de chaque échantillon Yn, suivant l'influence des variations thermiques sur la fonction de transfert du quadripôle à linéariser, et la précision de compensation recherchée.

On notera qu'un tel dispositif de compensation complémentaire des dérives en températures est inutile dans les modes de réalisation des figures 5 et 6 où la répétition du calcul des échantillons de commande $C_n$ s'effectue à intervalles suffisamment courts.

L'invention trouve une application préférentielle pour la linéarisation des quadripôles à fonction de transfert dissymétrique, fonctionnant en basse fréquence.

A titre d'exemple, les figures 8a, 8b, 9,10 se rapportent à des circuits de linéarisation d'un optocoupleur du type représenté en figure 11.

Ces montages sont particulièrement bien adaptés au traitement de signaux BF et permettent d'obtenir une excellente précision de l'opération de linéarisation malgré les problèmes posés par la polarisation de l'optocoupleur, et la forme dissymétrique de la courbe de transfert.

Les diodes émissives 111 des optocoupleurs 110 (fig.11) sont généralement polarisées. Le niveau de polarisation est transmis intégralement par la diode réceptrice 112, ce qui peut parfois provoquer des saturations. Aussi, supprime-t-on généralement la composante continue, par une liaison capacitive 80.

La présence de cette capacité 80 conduit à décaler la plage de correction d'une valeur égale à la valeur de polarisation, par rapport à la plage considérée.

Ceci est réalisé par la présence d'une boucle spécifique 82 de repolarisation, à côté de la boucle 81 d'échantillonnage des signaux Y de sortie de l'optocoupleur 110. La branche 81 fournit ainsi les échantillons numériques Yn obtenus en sortie de l'échantillonneur-bloqueur 83 et du circuit analogique numérique 84. De son côté, la branche 82 fournit des échantillons numériques Ynp, correspondant à la tension de polarisation de l'optocoupleur 110.

Les échantillons Yn et Ynp alimentent deux entrées d'un circuit additionneur 86 chargé d'adresser la mémoire PROM 87 qui commande le multiplieur 88.

La tension de polarisation POL est prélevée sans perte, puis amplifiée dans l'amplificateur limiteur 89 tenant compte du gain de l'optocoupleur 110. La variation de la tension de polarisation POL étant faible par rapport à l'excursion maximale, le gain de l'amplificateur 89 est porté à quatre fois le gain de l'optocoupleur 110. Ceci permet d'utiliser un circuit de conversion analogique numérique 85 de dynamique plus importante (en l'occurrence plus ou moins 5 Volts, au lieu de plus ou moins 1 Volt, ce qui est plus difficile à trouver). La division par quatre permettant de rétablir la vraie valeur des échantillons numériques Ynp à la sortie du convertisseur 85 est simplement réalisée au montage du bus de sortie, en éliminant les deux bits de poids les plus faibles (décalage à gauche des bits de Ynp).

Dans ce mode de réalisation, les composants sont avantageusement les suivants :

- optocoupleur 110 : 6N 135 HP
- amplificateur limiteur 89 et amplificateur de sortie 120 : TL072
- échantillonneur-bloqueur 83 : MP 260
- convertisseurs analogique-numérique 84, 85 : AD 572 (12eb) et AD 575 (10eb) respectivement
- additionneur 86 : 4 N74 283
- mémoire PROM 87 : 2732
- multiplieur 88 : AD 7535.

La figure 8b représente une version du circuit de linéarisation analogue à celui de la figure 8a, dans laquelle la branche de repolarisation 122 est entièrement analogique.

Dans ce cas, l'addition du signal analogique y de sortie de l'optocoupleur 110 avec la référence de polarisation $y_p$ amplifiée par l'amplificateur limiteur 126 s'effectue par simple conjonction 123. Le signal analogique combiné est ensuite numérisé à travers l'échantillonneur-bloqueur 124 et le circuit analogique 125, avant d'adresser la mémoire PROM 87 de commande du multiplieur 88.

La prise en compte de la tension de polarisation dans les branches 82, 122 des circuits des figures 8a, 8b permet de compenser la dérive des caractéristiques de l'optocoupleur 110 en fonction du vieillissement et/ou de la température. Toutefois, dans le cas où la dérive est supposée faible, cette boucle n'est pas nécessaire, et il est possible d'ajouter une valeur constante estimée aux échantillons Yn.

La figure 9 illustre un mode de réalisation d'un circuit de linéarisation pour optocoupleur polarisé selon l'invention, dans une version autoadaptative. La figure 10 est un organigramme fournissant le principe de fonctionnement de ce montage.

L'objectif est de prélever d'instant en instant la valeur du signal BF d'entrée de l'optocoupleur 110, de façon à faire calculer par un microprocesseur 90 la valeur des échantillons de commande du multiplieur 88 assurant la restitution fidèle du signal BF à l'entrée de l'amplificateur de sortie 120 tel qu'il était à l'entrée de l'optocoupleur 110.

Pour ce faire, le circuit de la figure 9 comprend un commutateur 91, qui connecte l'entrée de l'optocoupleur 110 en alternance avec le signal BF d'une part (position 1), et avec un signal de type "rampe" produit par le microprocesseur 90 d'autre part (position 2).

On retrouve dans ce circuit de la figure 9 les deux branches 93 et 92 correspondant à la génération des échantillons Yn et Ynp respectivement, déjà existants dans les circuits des figures 8a, 8b. Toutefois, un second commutateur $I_2$ 94 permet de sélectivement neutraliser l'amplificateur limiteur 95. Dans la position de neutralisation du commutateur 94, le convertisseur analogique-numérique 96 ne fournit alors plus en sortie un échantillon Ynp, mais contraire un échantillon Xnp.

Les circuits tampons 131, 132, 133 servent d'interface entre le bus du microprocesseur 90, et le bus de commande du multiplieur 88, et les CAN 96, 98.

Enfin, la branche 134 permettant d'alimenter l'optocoupleur 110 par un signal produit par le microprocesseur 90, lorsque le commutateur $I_1$ 91 est en position 2, comporte un convertisseur numérique analogique 135, suivi d'un composant de dépointage ("deglitching") 136.

On trouve également un composant de dépointage 137 en sortie de l'amplificateur de sortie 120. Ces composants de dépointage ont l'avantage de supprimer les transitoires des signaux, sans atténuation (à la différence des filtres de lissage).

On peut décomposer le fonctionnement de la version autoadaptative du circuit de linéarisation, en trois phases successives, telles que délimitées en fig.10 :

- la phase A, consistant à déterminer une valeur de pente de référence (Cnp) pour l'opération de linéarisation, en un point de référence de la courbe correspondant au point de polarisation;
- la phase B consistant à prélever la valeur courante du signal en sortie de l'optocoupleur, puis à la numériser avec décalage pour tenir compte de la polarisation;
- la phase C consistant à calculer, pour l'état courant y du signal, l'échantillon de correction Cn qui va permettre la restitution, en sortie du multiplieur 88, d'un signal identique (x) au signal BF d'entrée dans l'optocoupleur 110.

On comprend que ce principe de fonctionnement en trois phases A, B, C n'est applicable que lorsque les temps de commutation des interrupteurs $I_1$, $I_2$ (202, 204, 207, 210 216), et surtout les temps de traitement 206, 209, 211 à 220, sont très faibles par rapport au temps de variation du signal x,y. On peut considérer à cet égard qu'aucune distortion ne sera introduite dans le signal principal si l'ensemble du cycle (phase A + B + C) est réalisé en au plus 1/10 de la période du signal principal.

Cette contrainte est parfaitement compatible pour les signaux BF, avec les composants actuellement disponibles sur le marché.

En phase A, lorsque le cycle de la fig.10 a été initialisé (201), on positionne l'interrupteur $I_1$ 91 en position (2) (interruptions du signal BF d'entrée dans l'optocoupleur 110) (202), et on amène le commutateur $I_2$ 94 en position (2) (neutralisation de l'amplificateur limiteur 95). Ceci permet de mesurer un échantillon Xnp 203. L'interrupteur $I_2$ 94 est ensuite commuté en position (1), de façon à obtenir un échantillon Ynp 205, puis à calculer la valeur de pente de référence Cnp 206 qui sera mémorisée, par exemple en un emplacement $M_R$ de la RAM du microprocesseur 90.

En phase B, le commutateur $I_1$ 91 est momentanément replacé en position 1, de façon à prélever la valeur courante du signal BF, tel que fourni en sortie de l'optocoupleur 110 (y). Le signal analogique y est transformé en échantillon numérique Yn 208, qui est additionné à l'échantillon Ynp précédemment calculé, et placé en un emplacement M1 de la RAM du microprocesseur 90 (209).

La phase C présente trois branches principales 222, 223, 220 correspondant aux cas où Yn > Ynp (l'échantillon se trouve au-dessus du point de référence sur la courbe de transfert) (222), au cas où Yn < Ynp (le signal courant se trouve au-dessous du point de référence) (223), et le cas où Yn = Ynp (le signal courant est exactement au point de référence) (220).

Dans la branche 222, c'est-à-dire lorsque le signal courant est supérieur au point de référence, le microprocesseur 90 va produire une incrémentation du signal d'entrée de l'optocoupleur 110, via la branche 134 du circuit de la figure 9, de façon à retrouver la valeur du signal BF d'entrée x générant le signal y de sortie. Lorsque le test 214 est positif, on procède alors au calcul de l'échantillon de correction Cn (215), qui sera ensuite appliqué au multiplieur 88 de façon à restituer le signal x en sortie du multiplieur 88.

Au contraire, dans la branche 223, où le signal courant y se trouve en-dessous du point de référence (point de polarisation), le microprocesseur va décrémenter les échantillons Xn convertis et acheminés en 135, 136, 134 jusque dans l'optocoupleur 110, de façon à retrouver la valeur x du signal d'entrée. Lorsque ce signal x a été retrouvé, on calcule ensuite en 215 l'échantillon de correction Cn.

Enfin, dans le cas où il se trouve que le signal analogique prélevé en phase B correspond exactement au point de référence, l'échantillon de correction Cn calculé en 220 est identique à celui calculé en 206.

En tout état de cause, à la fin de chacune des branches 222, 223, 220, on débloque les tampons de communication avec le multiplieur 88, et on replace l'interrupteur $I_1$ en position (1) pour rétablir l'alimentation de l'optocoupleur 110 par le signal BF.

Les montages des figures 8a, 8b et 9 peuvent présenter quelques variantes.

Ainsi, le multiplieur 88 à commande numérique de la figure 9 est plus précis qu'un multiplieur analogique (0,006% SF pour le AD 7536, contre 0,5% FS pour le AD 534).

Toutefois, selon une autre approche intéressante, on peut remplacer le multiplieur par un multiplieur logarithmique, encore appelé atténuateur numérique, du type AD 7111 - 7115 ou 7118, en fonction de la résolution souhaitée. Les procédés de fonctionnement sont similaires à ceux déjà décrits. Néanmoins, pour des raisons de simplicité, la version de la figure 8b, à repolarisation analogique, est préférable. Lors de l'utilisation d'un multiplieur logarithmique, on utilise également des convertisseurs analogique-numérique logarithmique, et les calculs des échantillons Cn deviennent très simples :

LOG Cn = LOG Xn - LOG Yn.

On pourrait alors choisir, par exemple, un pas de 0,1 dB pour incrémenter Xn dans le cas de l'AD 7115.

Les applications de l'invention sont très diverses.

Ainsi, l'invention trouve à s'appliquer pour la correction de la non linéarité des courbes de transfert symétriques (amplificateur de classe B ou C, courbes de premire aimantation), ou de courbes dissymétriques (courbe sensitométrique, jonctions PN, diodes, transistors, diodes LED).

La non linéarité des diodes LED oblige à travailler sur de petits signaux. A titre d'exemple, sur un optocoupleur 6N 135 "Hewlett-Packard (Nom Commercial), l'excursion maximale admissible est de plus ou moins 2 mA, alors que la partie exploitable de la courbe s'étale sur 30 mA ; dans ce cas, l'affaiblissement de distortion est de 50 dB (0,3%), et le rapport signal sur bruit de 80dB. Un exemple d'optocoupleur, tel que représenté en figure 11, peut être trouvé dans la demande de brevet antérieure 83 14920 du 20/09/1983.

Grâce aux circuits décrits, pour lesquels on a choisi une résolution des composants de 12 eb (pour limiter la taille de la PROM à 4 Ko) on obtient des affaiblissement de près de 70 dB en distortion, et 102 dB en bruit. Avec une plus grande résolution, et une amplification à l'entrée de l'optocoupleur, on devrait pouvoir atteindre 80 dB d'affaiblissement de distortion, et près de 120 dB de rapport signal sur bruit.

Il est clair que l'invention telle que décrite pour la linéarisation des optocoupleurs s'étend également à la linéarisation d'autres composants électroniques, dont les capteurs de température, les systèmes de transmission de flux lumineux en fonction d'un champ électrique appliqué (enregistrement photographique au moyen d'une cellule de Kerr), ou encore les lampes à lueur (modulateurs de lumière).

En conclusion, le procédé et les circuits objets de l'invention, fournissent des moyens de linéarisation de tout quadripôle, pourvu que sa fonction de transfert puisse être numérisée. Les différentes versions présentées illustrent quelques applications non limitatives de l'invention, et en montrent les nombreux avantages.

Bien entendu, l'invention ne se limite pas au mode de réalisation particulier décrit, ni au type de quadripôle mentionné. Signalons à cet égard, à titre d'autres exemples non limitatif d'application de l'invention, la linéarisation de circuits de transmission optique sans contre réaction, ou encore la linéarisation de capteurs de différents paramètres physiques, tels que la pression, la température, le déplacement, la vitesse etc...

## Revendications

**1.** Un dispositif autoadaptatif pour linéariser la fonction de transfert d'un quadripôle (10), le quadripôle délivrant un premier signal de sortie en réponse à un premier signal d'entrée selon des caractéristiques de réponse en amplitude connues, le dispositif comprenant un moyen (54) de conversion analogique/numérique pour numériser le premier signal de sortie, un moyen (60) de mémorisation de coefficients de correction des caractéristiques de réponse en amplitude du quadripôle, adressé par le moyen de numérisation, un moyen (11) de correction du premier signal de sortie commandé par le moyen de mémorisation pour compenser les défauts de linéarité du quadripôle,

caractérisé en ce qu'il comprend en outre:

- un moyen (31; fig 6; fig 7) générateur d'échantillons numériques;
- un moyen (53) de conversion numérique/analogique sensible au moyen générateur pour fournir un second signal d'entrée;
- un moyen (50) sélecteur de signaux analogiques, sensible au moyen générateur, pour fournir l'un des deux signaux d'entrée au quadripôle et pour fournir un second signal de sortie du quadripôle au moyen de conversion analogique/numérique lorsque le second signal d'entrée est fourni au quadripôle;
- un moyen (55) de commande et de calcul relié au moyen de mémorisation, au moyen de conversion analogique/numérique et au moyen générateur d'échantillons numériques pour charger dans le moyen de mémorisation des nouveaux coefficients de correction, les nouveaux coefficients de correction étant calculés à partir des échantillons numériques et du second signal de sortie numérisé.

**2.** Le dispositif selon la revendication 1, dans lequel le moyen générateur (31; fig 5) fournit périodiquement des échantillons numériques.

**3.** Le dispositif selon la revendication 1, dans lequel le moyen sélecteur (50; fig 6) est agencé pour fournir sélectivement le premier signal d'entrée ou le premier signal de sortie au moyen de conversion analogique/numérique (53) pour faire une mesure de linéarité différentielle.

**4.** Le dispositif selon les revendications 1 ou 2, dans lequel le quadripôle est un optocoupleur (110; fig. 8a) ayant une première entrée pour recevoir un premier signal d'entrée principal basse fréquence et une seconde entrée pour recevoir un signal de polarisation, le moyen de mémorisation (87) étant en outre sensible au signal de polarisation.

**5.** Le dispositif selon la revendication 4, dans lequel le moyen de conversion analogique/numérique (125; fig. 8b) numérise la conjonction du premier signal d'entrée et du signal de polarisation.

**6.** Le dispositif selon la revendication 5, comprenant en outre un moyen (85; fig. 8a) pour numériser le signal de polarisation et un moyen (86) relié en sortie au moyen de numérisation pour additionner le premier signal d'entrée numérisé et le signal de polarisation numérisé.

**Claims**

1. A self-adapting device for linearizing the transfer function of a quadripole (10), the quadripole (10) delivering a first output signal in response to a first input signal according to known amplitude response characteristics, the device including an analog/digital conversion device (54) for digitizing the first output signal, a means (60) for memorizing the correction coefficients for the amplitude response characteristics of the quadripole, addressed by the digitizing means, a means (11) for correcting the first output signal controlled by the memory means for compensating the linearity defects of the quadripole,

   characterized in that it includes moreover:
   - a means (31) for generating digital samples;
   - a digital/analog conversion means (53) sensitive to the generating means so as to provide a second input signal;
   - a means (50) for selecting analog signals, sensitive to the generating means so as to supply one of the two input signals to the quadripole and to supply a second output signal from the quadripole to the analog/digital conversion means when the second input signal has been supplied to the quadripole;
   - a control and computing means (55) connected to the memory means, to the analog/digital conversion means and to the means for generating digital samples for loading new correction coefficients into the memory means, the new correction coefficients being calculated from the digital samples and from the second digitized output signal.

2. Device according to claim 1, wherein the generating means (31) periodically provides digital samples.

3. Device according to claim 1, wherein the selecting means (50) is arranged so as to supply selectively the first input signal or the first output signal to the analog/digital conversion means (53) for effecting a differential linearity measurement.

4. Device according to claims 1 or 2, wherein the quadripole is an optocoupler (110) having a first input for receiving a first main low frequency input signal and a second input for receiving a polarization signal, the memory means (87) being moreover sensitive to the polarization signal.

5. Device according to claim 4, wherein the analog/digital conversion means (125) digitizes the combination of the first input signal and of the polarization signal.

6. Device according to claim 5, including moreover a means (85) for digitizing the polarization signal and a means (86) connected at the output to the digitizing means for adding the first digitized input signal and the digitized polarization signal.

**Patentansprüche**

1. Selbsttätig einstellende Vorrichtung zum Linearisieren der Übertragungsfunktion eines Vierpols (10), wobei der Vierpol ein erstes Ausgangssignal in Abhängigkeit eines ersten Eingangssignals gemäß bekannter Charakteristiken der Amplitudenkennlinie liefert, welche Vorrichtung eine Analog/Digital-Wandlereinrichtung (54) zum Digitalisieren des ersten Ausgangssignals, eine Speichereinrichtung (60) für Korrekturkoeffizienten der Amplitudenkennlinien-Charakteristika des Vierpols, die durch die Digitalisiereinrichtung adressierbar ist, eine Korrektureinrichtung (11) für das erste Ausgangssignal umfaßt, die durch die Speichereinrichtung gesteuert ist, um Linearitätsabweichungen des Vierpols zu kompensieren,

   dadurch gekennzeichnet, daß die Vorrichtung weiterhin umfaßt:
   - eine Generatoreinrichtung (31; Fig. 6; Fig. 7) für numerische Sampling-Werte;
   - eine auf die Generatoreinrichtung ansprechende Digital/Analog-Wandlereinrichtung (53) zur Erzeugung eines zweiten Eingangssignals;
   - eine auf die Generatoreinrichtung ansprechende Selektionseinrichtung (50) für analoge Signale zur Abgabe eines der beiden Eingangssignale an den Vierpol und zur Übertragung eines zweiten Ausgangssignals vom Vierpol zu der Analog/Digital-Wandlereinrichtung, wenn das zweite Eingangssignal an den Vierpol abgegeben worden ist;

- eine Steuer- und Recheneinrichtung (55), die mit der Speichereinrichtung, der Analog/Digital-Wandlereinrichtung und der Generatoreinrichtung für numerische Sampling-Werte verbunden ist, um der Speichereinrichtung die neuen Korrekturkoeffizienten zuzuführen, wobei die neuen Korrekturkoeffizienten aus den numerischen Sampling-Werten und dem digitalisierten zweiten Ausgangssignal berechnet worden sind.

**2.** Vorrichtung nach Anspruch 1, wobei die Generatoreinrichtung (31; Fig. 5) die numerischen Sampling-Werte periodisch liefert.

**3.** Vorrichtung nach Anspruch 1, wobei die Selektionseinrichtung (50; Fig. 6) so ausgelegt ist, daß sie selektiv das erste Eingangssignal oder das erste Ausgangssignal an die Analog/Digital-Wandlereinrichtung (53) liefert, um eine Messung der differentiellen Linearität auszuführen.

**4.** Vorrichtung nach den Ansprüchen 1 oder 2, wobei der Vierpol ein Optokoppler (110; Fig. 8a) ist, der einen ersten Eingang zum Empfang eines ersten, im wesentlichen niederfrequenten Eingangssignals und einen zweiten Eingang zum Empfang eines Polarisationssignals aufweist, wobei die Speichereinrichtung (87) unter anderem auf das Polarisationssignal anspricht.

**5.** Vorrichtung nach Anspruch 4, wobei die Analog/Digital-Wandlereinrichtung (125; Fig. 8b) die Konjunktion des ersten Eingangssignals und des Polarisationssignals digitalisiert.

**6.** Vorrichtung nach Anspruch 5, umfassend weiterhin eine Einrichtung (85; Fig. 8a) zur Digitalisierung des Vorspannungssignals und eine Einrichtung (86), die mit dem Ausgang der Digitalisiereinrichtung verbunden ist, um das erste digitalisierte Eingangssignal und das digitalisierte Polarisation zu addieren.

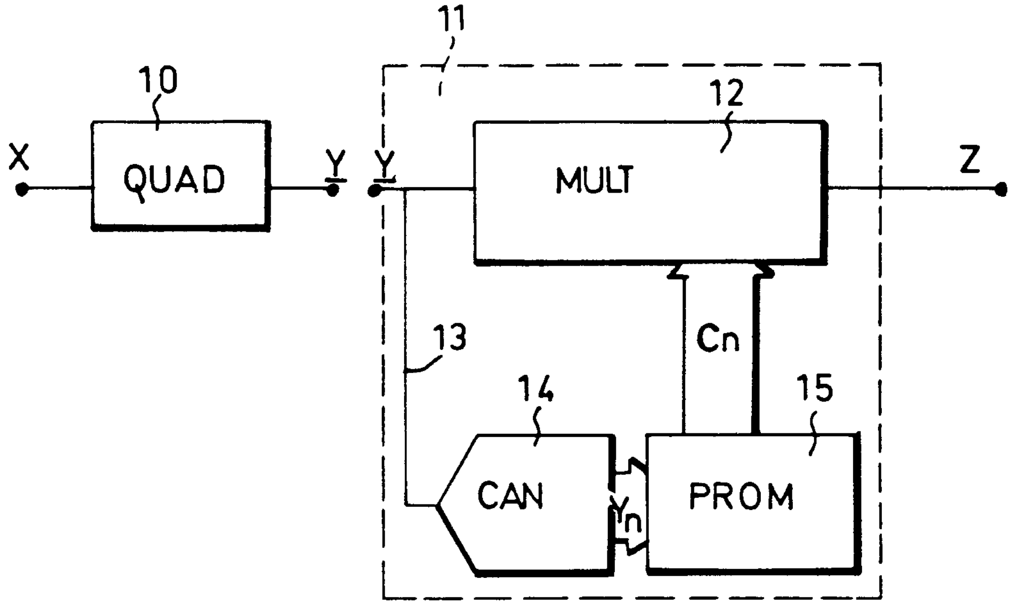
11
10
12
X
QUAD
Y
Y
MULT
Z
13
Cn
14
15
CAN
Yn
PROM

FIG.1

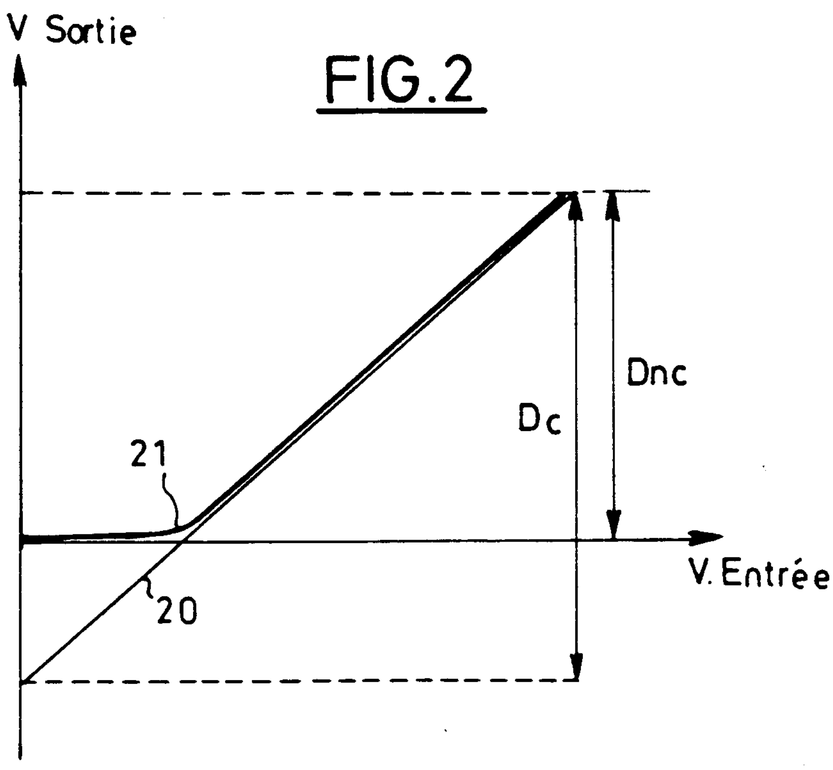
V Sortie
Dnc
Dc
21
V. Entrée
20

FIG.2

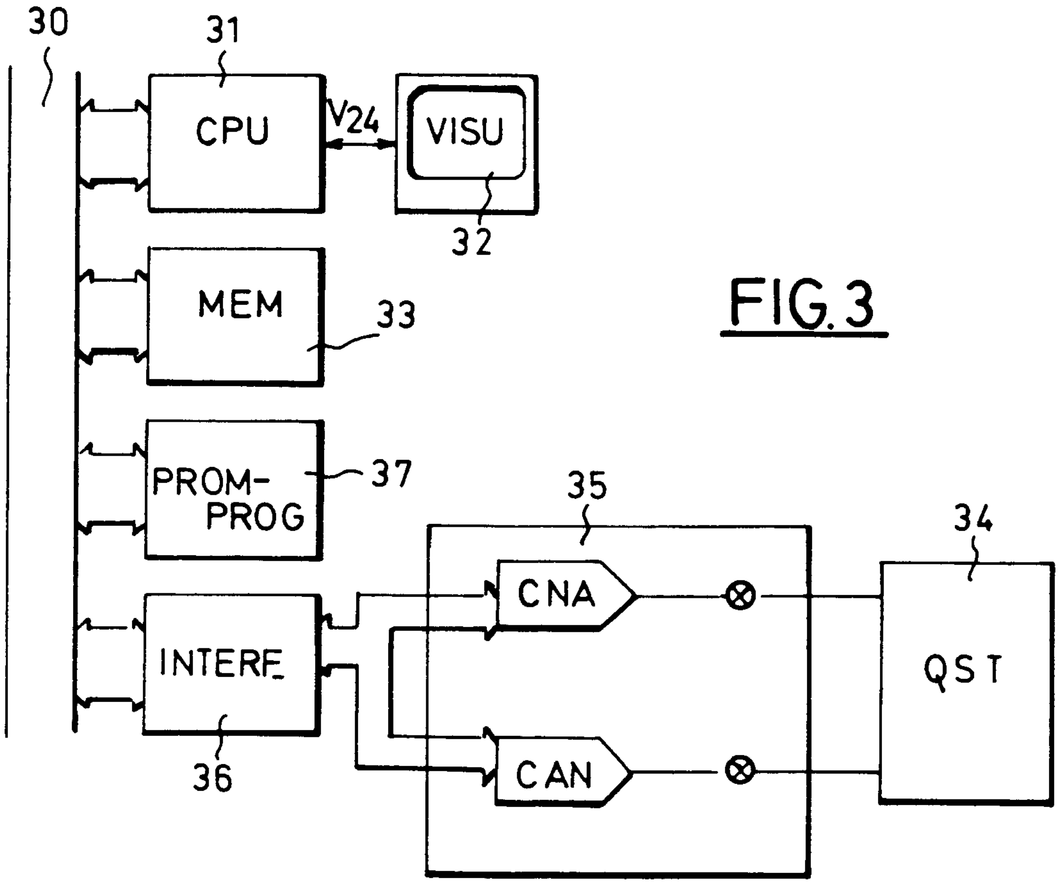
30
31
CPU
V24
VISU
32
MEM
33
PROM-
PROG
37
35
34
CNA
INTERF
QST
CAN
36

FIG. 3

FIG. 5

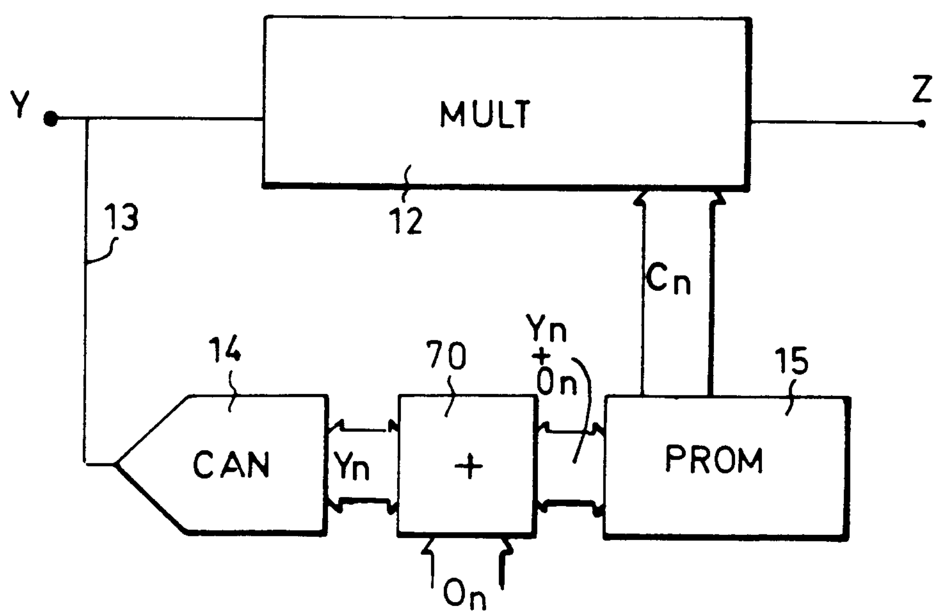
Y
MULT
Z
12
13
Cn
14
70
Yn
+
On
15
CAN
Yn
+
PROM
On

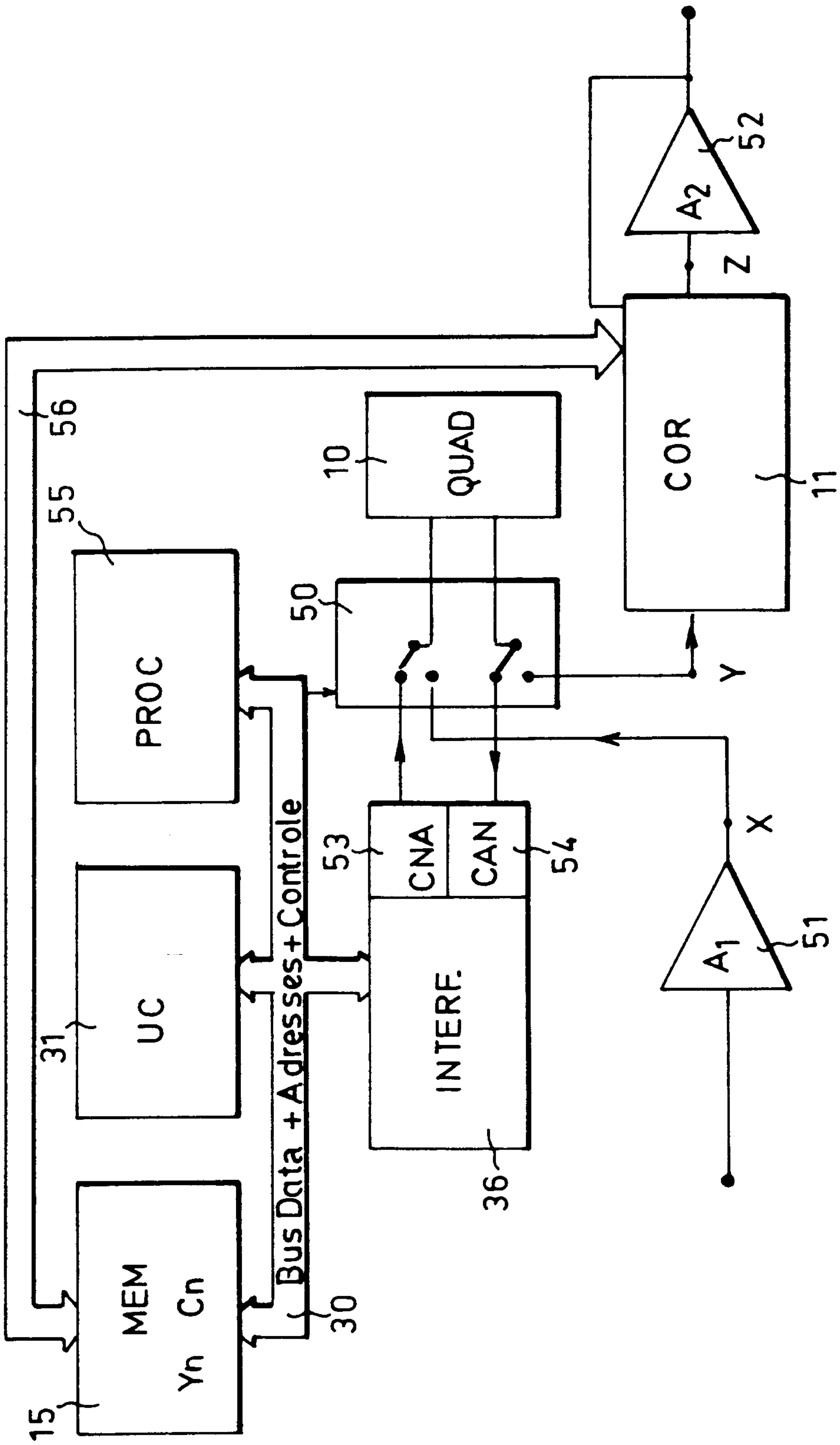
MEM
Yn
Cn
15
UC
31
PROC
55
56
Bus Data + Adresses + Controle
30
INTERF.
36
CNA
53
CAN
54
50
QUAD
10
COR
11
A1
51
A2
52
X
Y
Z

FIG.6

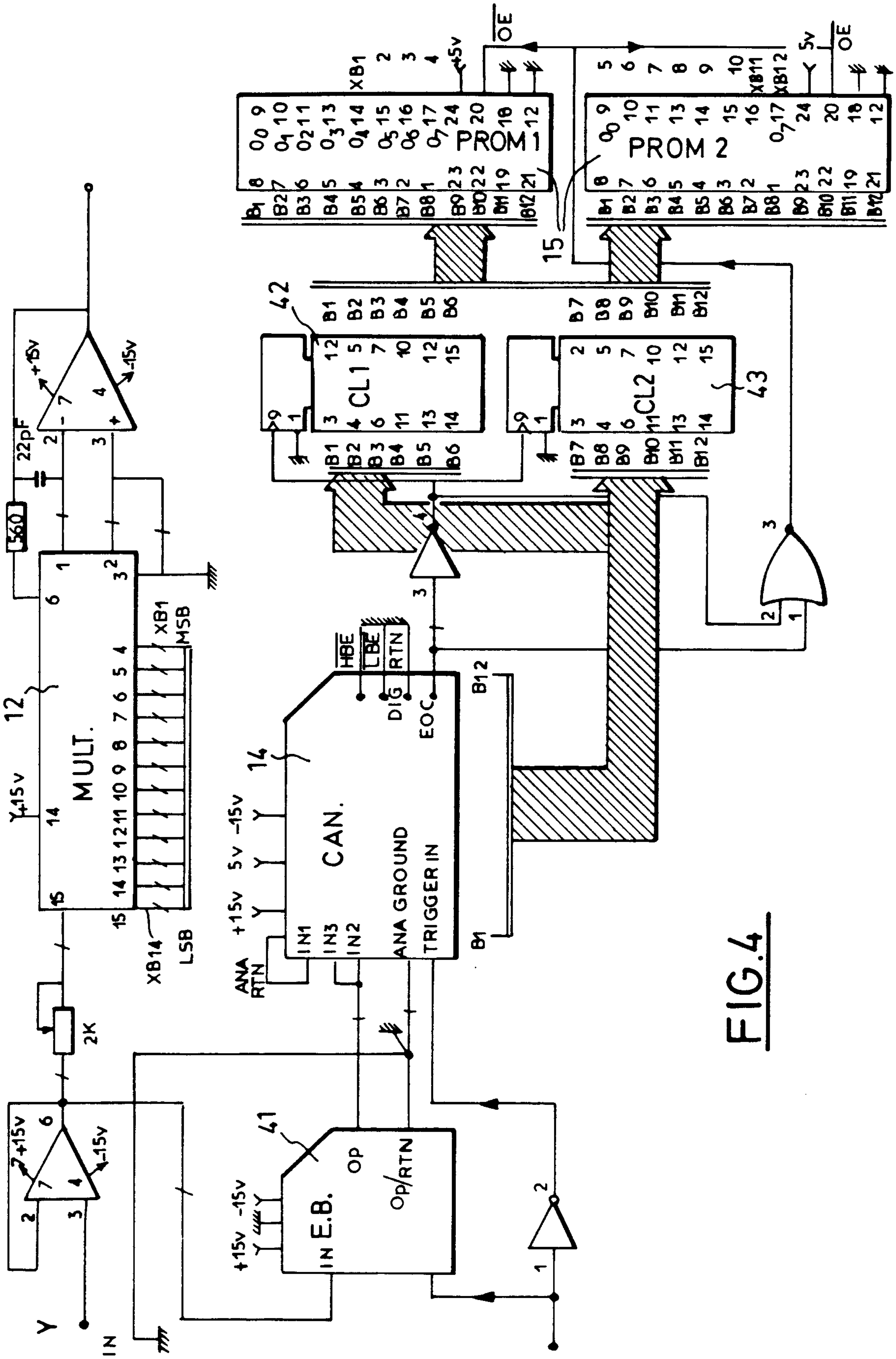


FIG.4

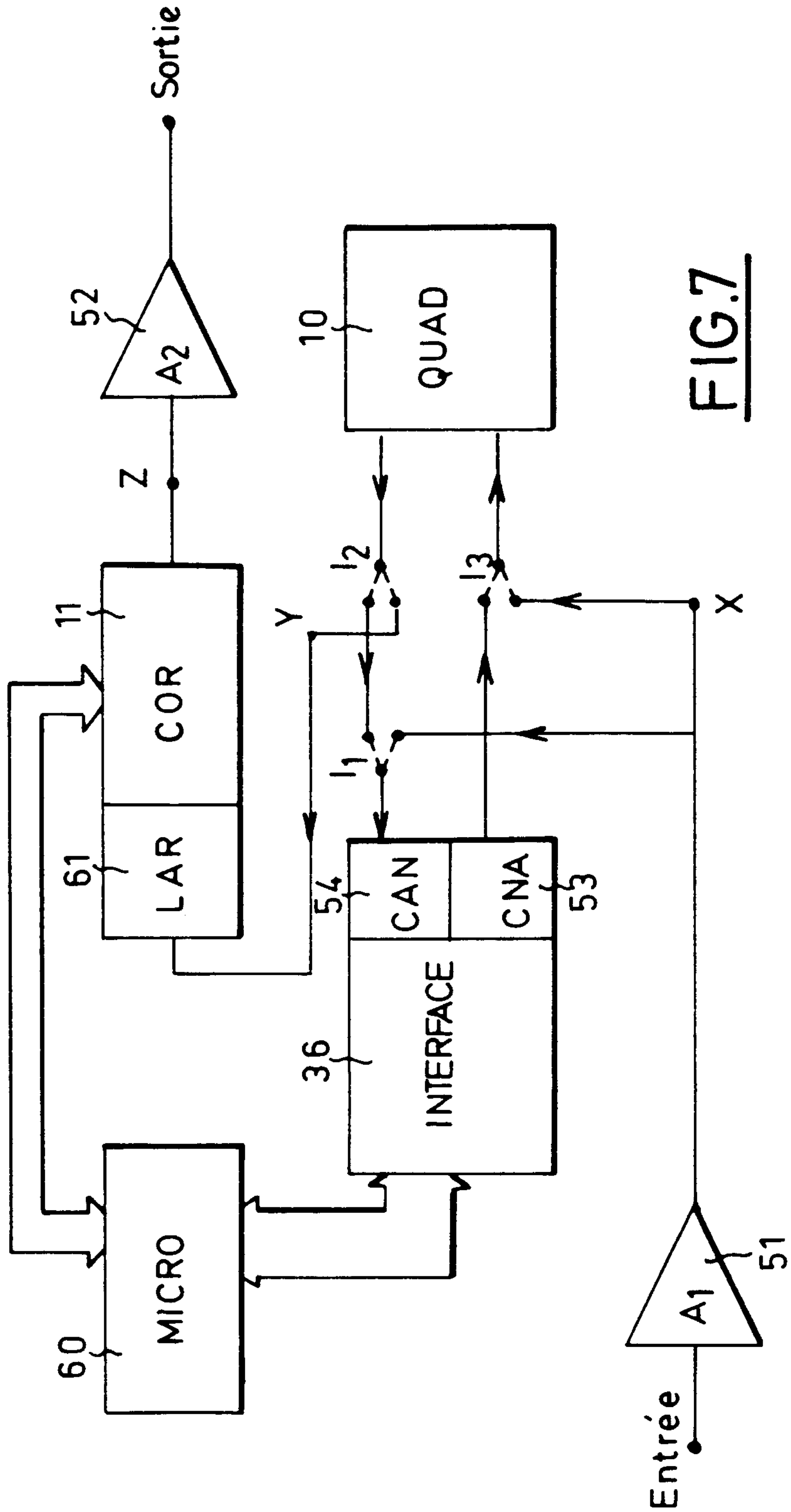

Sortie
52
A2
Z
11
COR
61
LAR
Y
10
QUAD
I2
I3
I1
X
54
CAN
CNA
53
36
INTERFACE
60
MICRO
51
A1
Entrée


FIG.7

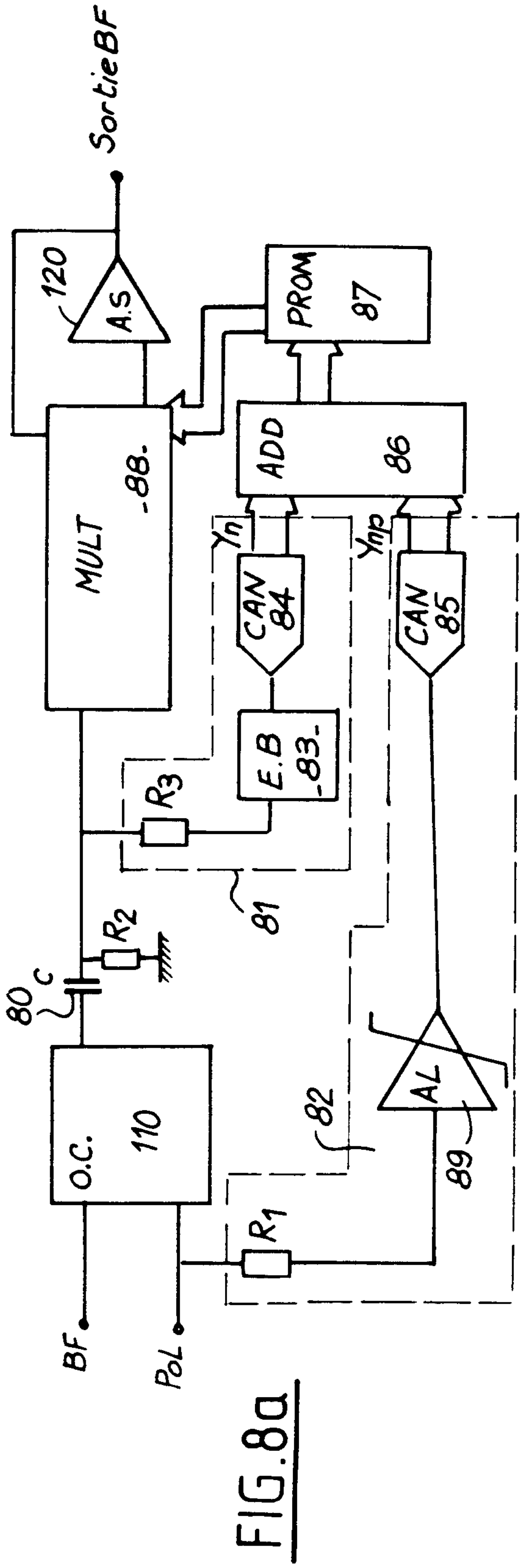
Sortie BF
120
A.S
PROM
87
ADD
86
MULT
88
Yn
Ynp
CAN
84
CAN
85
E.B
83
R3
81
R2
80
C
O.C.
110
82
AL
89
R1
BF
PoL

FIG.8a

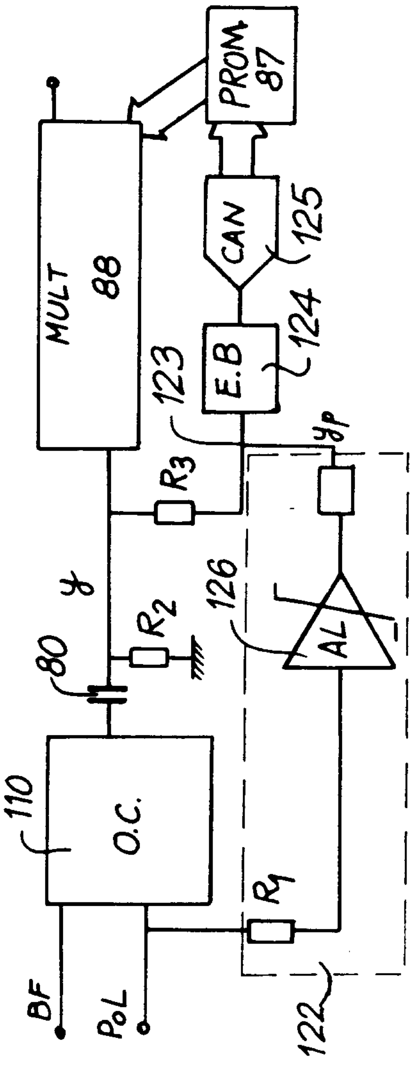
PROM
87
MULT
88
CAN
125
124
E.B
123
yp
R3
y
R2
126
AL
80
110
O.C.
R1
BF
PoL
122

FIG.8b

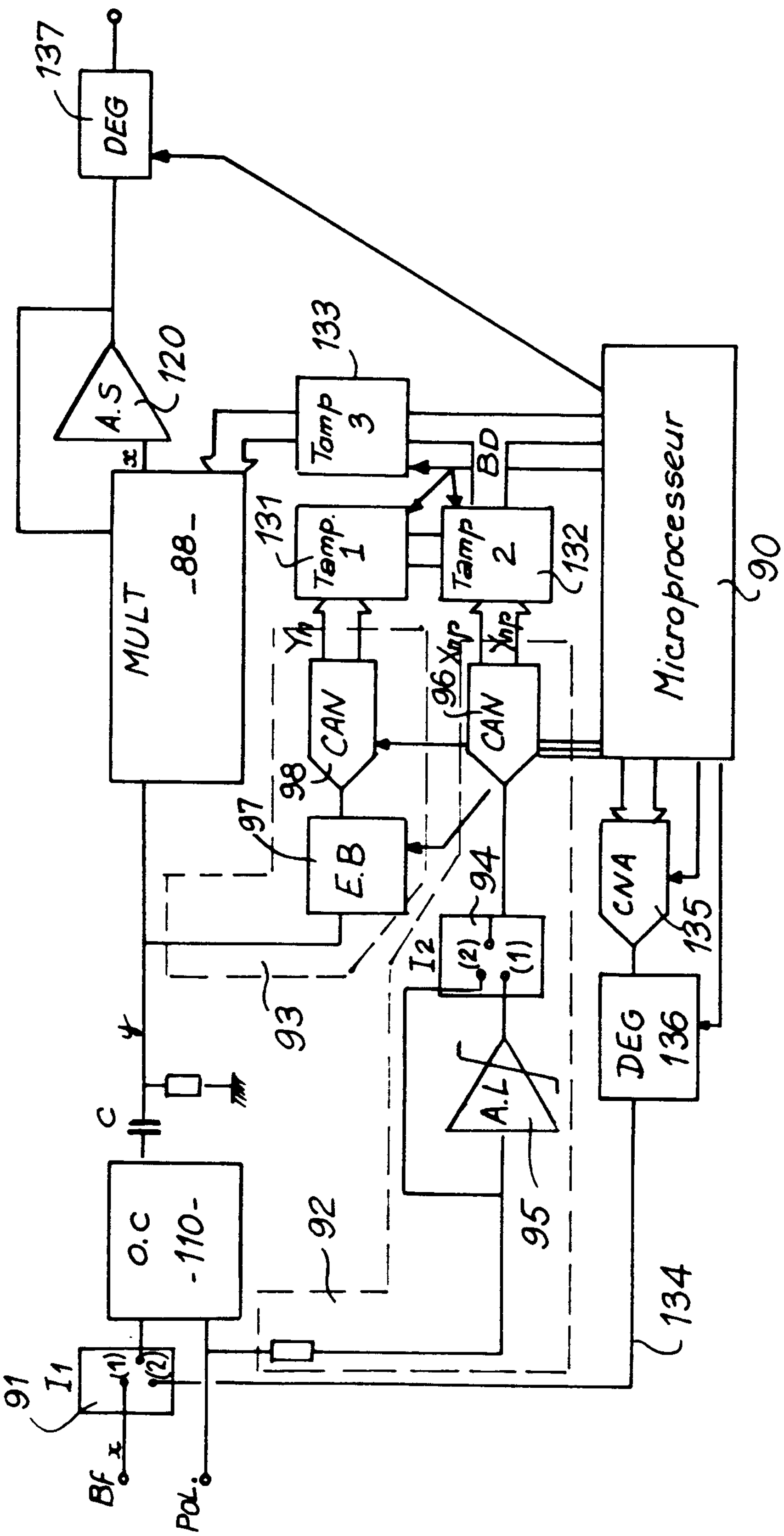
137
DEG
A.S
120
x
MULT
-88-
133
Tamp 3
131
Tamp. 1
Tamp 2
132
BD
Microprocesseur
90
Yn
96
Xnp
Ynp
CAN
CAN
98
97
E.B
94
I2
(2)
(1)
CNA
135
DEG
136
93
A.L
95
C
y
O.C
-110-
92
134
91
I1
(1)
(2)
BFx
Pol.

FIG.9

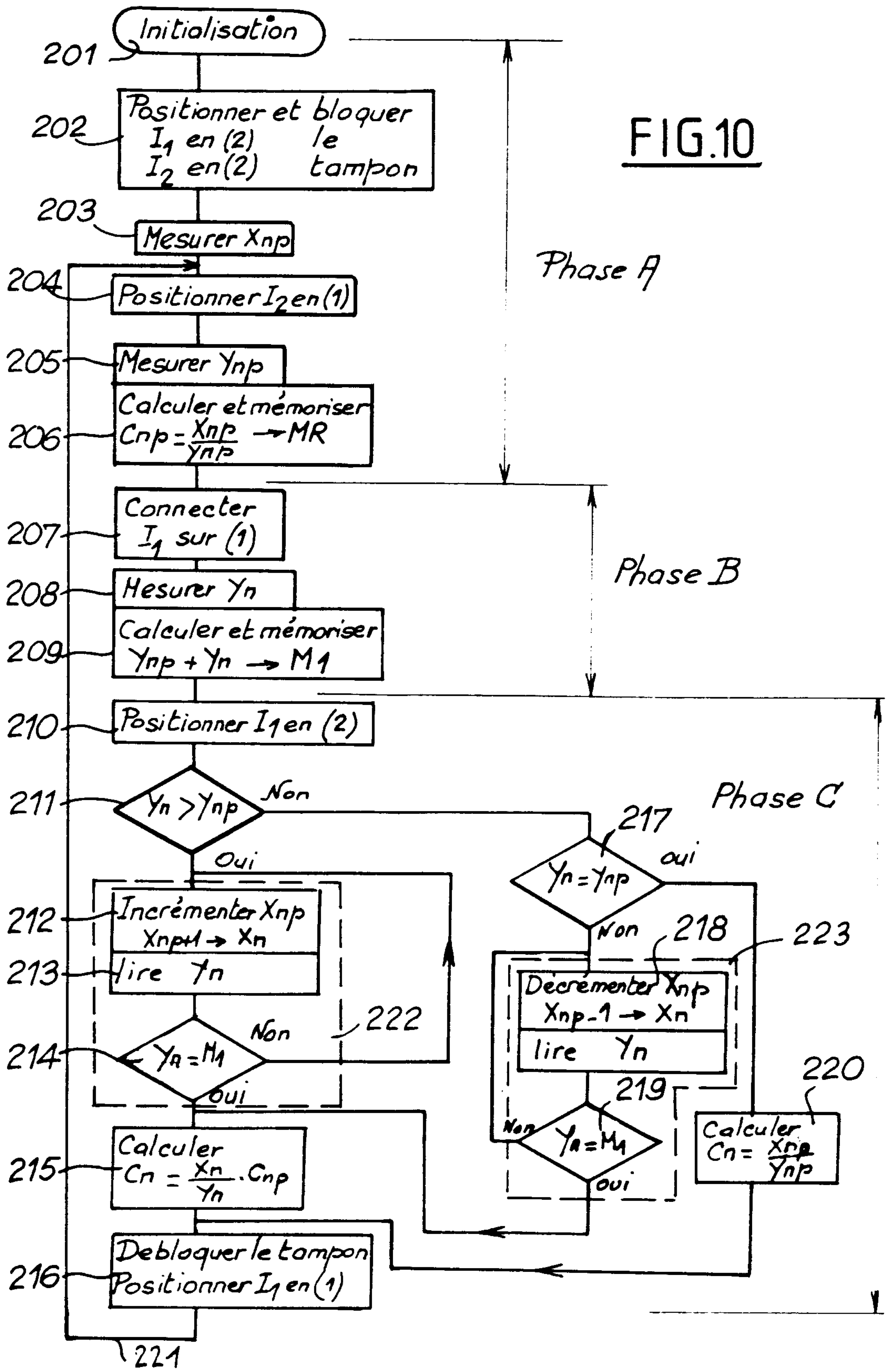
Initialisation
201
Positionner et bloquer I1 en (2) I2 en (2) le tampon
202
Mesurer Xnp
203
Positionner I2 en (1)
204
Mesurer Ynp
205
Calculer et mémoriser Cnp = Xnp/Ynp → MR
206
Connecter I1 sur (1)
207
Mesurer Yn
208
Calculer et mémoriser Ynp + Yn → M1
209
Positionner I1 en (2)
210
Yn > Ynp
211
Non
Oui
Incrémenter Xnp Xnp+1 → Xn
212
lire Yn
213
Yn = M1
214
Non
oui
222
Calculer Cn = Xn/Yn . Cnp
215
Debloquer le tampon Positionner I1 en (1)
216
221
Phase A
Phase B
Phase C
Yn = Ynp
217
oui
Non
Décrémenter Xnp Xnp-1 → Xn
218
lire Yn
223
Yn = M1
219
Non
oui
Calculer Cn = Xnp/Ynp
220

FIG.10

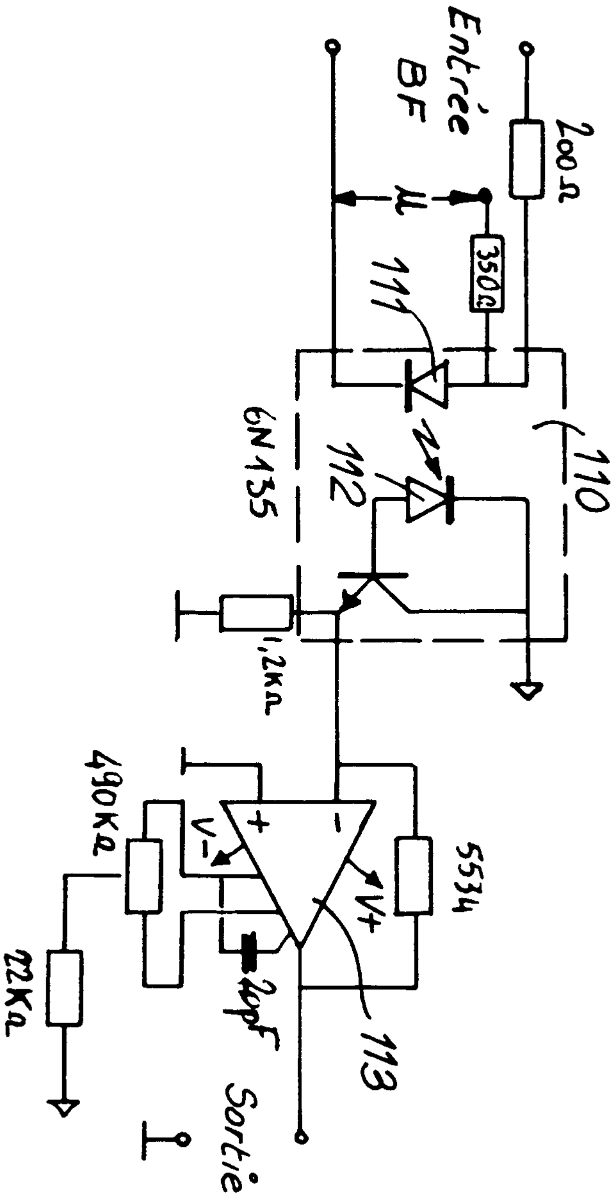
Entrée
BF
200Ω
350Ω
111
110
112
6N135
1,2KΩ
490KΩ
22KΩ
5534
V+
V-
20pF
113
Sortie

FIG.11